# EUROPÄISCHE PATENTANMELDUNG

(11) **EP 4 439 098 A1**
(43) Veröffentlichungstag der Anmeldung: **02.10.2024**
(21) Anmeldenummer: 23164294.3
(22) Anmeldetag: 27.03.2023
(51) Int. Cl.: G01R 31/28, G01R 31/40

(54) **TEMPERATURFELDÜBERWACHUNG ZUR ABSCHÄTZUNG DER RESTLEBENSDAUER EINER LEISTUNGSELEKTRONIKBAUGRUPPE**

(71) Anmelder: Siemens Aktiengesellschaft, 80333 München (DE)
(72) Erfinder: Dobs, Tom, 10553 Berlin (DE); Strogies, Jörg, 14163 Berlin (DE); Wilke, Klaus, 12527 Berlin (DE)
(74) Vertreter: Siemens Patent Attorneys

(57) **Zusammenfassung**

Die Erfindung gibt ein automatisiertes Verfahren zur Abschätzung der temperaturbedingten Restlebensdauer (10) einer Leistungselektronikbaugruppe (1) an, wobei die Leistungselektronikbaugruppe (1) mindestens einen, betriebsbedingt Verlustwärme abgebenden, schaltbaren Leistungshalbleiter (2) sowie mehrere Temperaturmesssensoren (3) aufweist. Das Verfahren hat folgende Schritte:
- ein Anlegen (101) einer Betriebsspannung an die Leistungselektronikbaugruppe (1),
- ein Ansteuern (102) des Leistungshalbleiters (2) mit einer vordefinierten Schaltpulsfolge (7),
- ein Ermitteln (103) von zeitlichen Temperaturverläufen (9) durch die Temperaturmesssensoren (3), und
- ein Abschätzen (104) der temperaturbedingten Restlebensdauer (10) der Leistungselektronikbaugruppe (1) mit Hilfe eines computerimplementierten Modells (8.1) der temperaturbedingten Degradation der Leistungselektronikbaugruppe (1) anhand der ermittelten Temperaturverläufe (9).

Die Erfindung gibt auch eine zugehörige Vorrichtung zur Abschätzung der temperaturbedingten Restlebensdauer (10) einer Leistungselektronikbaugruppe (1) an.

## Beschreibung

### GEBIET DER ERFINDUNG

Die Erfindung betrifft ein automatisiertes Verfahren und eine Vorrichtung zur Abschätzung der temperaturbedingten Restlebensdauer einer Leistungselektronikbaugruppe.

Unabhängig vom grammatikalischen Geschlecht eines bestimmten Begriffes sind Personen mit männlicher, weiblicher oder anderer Geschlechteridentität mit umfasst.

### HINTERGRUND DER ERFINDUNG

Die Aufbau- und Verbindungstechnologie leistungselektronischer Aufbauten (auch als Leistungselektronikbaugruppe bezeichnet) degradiert im Betrieb durch extrinsische und intrinsische Belastungen. Insbesondere der Temperaturwechsel durch den Schaltbetrieb leistungselektronischer Halbleiterbauelemente führt zur thermozyklischen Wechselbelastung aufgrund unterschiedlicher Ausdehnungskoeffizienten der verbundenen Komponenten und schließlich zum degradationsbedingten Ausfall des Systems.

Typische Degradationsmechanismen sind dabei Risswachstum und Delamination im Wärmepfad, beispielsweise zwischen Leistungshalbleiterbauelementen und DCB-Substrat oder zwischen DCB-Substrat und Kühlkörper (Englisch: Heatsink). Durch die damit verbundene Verschlechterung der thermischen Leitfähigkeit verändern sich die thermischen Eigenschaften, wodurch weitere Fehlermechanismen getriggert werden können.

Leistungselektronische Aufbauten sind meist so integriert, dass eine zerstörungsfreie visuelle Analyse der Degradationsorte nicht möglich ist.

Ein bekanntes Verfahren zur Zustandsbestimmung in klassischen leistungselektronischen Aufbauten (bspw. IGBT-Modulen) ist die Temperaturüberwachung über ein als SMD-Komponente eingebrachten Heißleiterwiderstand (NTC). Die gemessene Temperatur wird mitgeloggt und zeigt eine Temperaturänderung in dem zu überwachenden System. Die Temperaturänderung gibt Aufschluss über den Zustand der verbauten Leistungshalbleiter und der Aufbau- und Verbindungstechnik der Leistungselektronikbaugruppe.

### ZUSAMMENFASSUNG DER ERFINDUNG

Es ist Aufgabe der Erfindung, eine Lösung anzugeben, die eine Restlebensdauer einer Leistungselektronilbaugruppe besser als im Stand der Technik offenbart abschätzen kann.

Die Erfindung ergibt sich aus den Merkmalen der unabhängigen Ansprüche. Vorteilhafte Weiterbildungen und Ausgestaltungen sind Gegenstand der abhängigen Ansprüche. Weitere Merkmale, Anwendungsmöglichkeiten und Vorteile der Erfindung ergeben sich aus der nachfolgenden Beschreibung.

In einem Aspekt der Erfindung wird die Lebensdauerabschätzung auf Basis eines empirischen Modells des Temperaturfeldes in einer Leistungselektronikbaugruppe abgeschätzt:
- Die Auswertung von Temperaturmesssensoren in der Leistungselektronikbaugruppe und von temperaturabhängigen elektrischen Kennwerten von Leistungshalbleitern ermöglicht die Abschätzung der momentanen herrschenden Temperaturverteilung, also des Temperaturfeldes.
- Im kalten Zustand der Leistungselektronikbaugruppe wird eine definierte Schaltpulsfolge des Leistungshalbleiters erzwungen und das transiente Temperaturfeld als Systemantwort auf die Schaltpulsfolge aufgenommen.
- Auf Basis von thermischen Modellen und empirischen Ausfalldaten der Leistungselektronikbaugruppe wird der Degradationsfortschritt abgeschätzt. Daraus wird die Restlebensdauer entsprechend dem Modell abgeschätzt.

Das offenbarte Verfahren bedingt die Einbringung der erforderlichen Messsensoren in das leistungselektronische Modul (= Leistungselektronikbaugruppe) und den Zugang zu temperaturabhängigen Parametern. Die Abschätzung des Degradationsfortschritts und damit der Restlebensdauer kann in Form einer Software beispielsweise auf einer Edge-Hardware realisiert werden.

Vorteilhaft ist auch die Auswertung als Cloud-Service bereitzustellen, wodurch eine Vielzahl von Modulen überwacht werden kann.

Das aus dem Stand der Technik bekannte Verfahren zur Überwachung von leistungselektronischen Modulen mittels eines NTCs basiert auf der Überwachung von nur einem Ort im System. Je nachdem wo ein Defekt im System auftritt, kann dieser unterschiedlich gut detektiert werden.

Das offenbarte Verfahren besitzt und zeigt eine gute Sensibilität und Auflösungsgenauigkeit des Temperaturprofils. Die Nutzung von empirischen Modellen ermöglicht die validierte Zustandsbestimmung des leistungselektronischen Moduls.

Die Erfindung beansprucht ein automatisiertes Verfahren zur Abschätzung der temperaturbedingten Restlebensdauer einer Leistungselektronikbaugruppe, wobei die Leistungselektronikbaugruppe mindestens einen, betriebsbedingt Verlustwärme abgebenden, schaltbaren Leistungshalbleiter sowie mehrere Temperaturmesssensoren aufweist. Das Verfahren umfasst folgende Schritte:
- ein Anlegen der Betriebsspannung an die Leistungselektronikbaugruppe,
- ein Ansteuern des Leistungshalbleiters mit einer vordefinierten Schaltpulsfolge,
- ein Ermitteln von zeitlichen Temperaturverläufen durch die Temperaturmesssensoren, und
- ein Abschätzen der temperaturbedingten Restlebensdauer der Leistungselektronikbaugruppe mit Hilfe eines computerimplementierten Modells der temperaturbedingten Degradation der Leistungselektronikbaugruppe anhand der ermittelten Temperaturverläufe.

Leistungshalbleiter sind Halbleiterbauelemente, die in der Leistungselektronik für das Steuern und Schalten hoher elektrischer Ströme und Spannungen ausgelegt sind (mehr als 1 Ampere und Spannungen von mehr als etwa 24 Volt).

In einer Weiterbildung des Verfahrens kann die Schaltpulsfolge eine vordefinierte Pulsfolgendauer aufweisen und die Temperaturverläufe können über eine vordefinierte Messdauer ermittelt werden.

In einer Weiterbildung des Verfahrens kann das computerimplementierte Modell empirisch an einer der Leistungselektronikbaugruppe identischen oder ähnlichen weiteren Leistungselektronikbaugruppe ermittelt werden.

In einer Weiterbildung des Verfahrens können an der weiteren Leistungselektronikbaugruppe empirische Ausfalldaten für das computerimplementierte Modell ermittelt werden.

In einer Weiterbildung des Verfahrens können die Ausfallsdaten durch eine künstliche Alterung der weiteren Leistungselektronikbaugruppe ermittelt werden.

In einer Weiterbildung des Verfahrens kann das computerimplementierte Modell ein thermisches Modell der Leistungselektronikbaugruppe aufweisen.

In einer Weiterbildung des Verfahrens kann das computerimplementierte Modell eine künstliche Intelligent aufweisen.

Die Erfindung beansprucht auch eine Vorrichtung zur Abschätzung der temperaturbedingten Restlebensdauer einer Leistungselektronikbaugruppe, wobei die Leistungselektronikbaugruppe mindestens einen, betriebsbedingt Verlustwärme abgebenden, schaltbaren Leistungshalbleiter sowie mehrere Temperaturmesssensoren aufweist. Die Vorrichtung weist ferner eine Recheneinheit auf, die ausgebildet und eingerichtet ist, bei einer angelegten Betriebsspannung an der Leistungselektronikbaugruppe,
- den Leistungshalbleiter mit einer vordefinierten Testpulsfolge anzusteuern,
- durch die Temperaturmesssensoren ermittelte zeitliche Temperaturverläufe zu erfassen, und
- die temperaturbedingte Restlebensdauer der Leistungselektronikbaugruppe mit Hilfe eines computerimplementierten Modells der temperaturbedingten Degradation der Leistungselektronikbaugruppe anhand der ermittelten Temperaturverläufe abzuschätzen.

In einer weiteren Ausführungsform der Vorrichtung kann die Recheneinheit als Edge-Hardware oder als Cloud-Service ausgebildet sein.

In einer weiteren Ausführungsform der Vorrichtung kann das computerimplementierte Modell empirisch an einer der Leistungselektronikbaugruppe identischen oder ähnlichen weiteren Leistungselektronikbaugruppe ermittelbar sein.

In einer weiteren Ausführungsform der Vorrichtung können an der weiteren Leistungselektronikbaugruppe empirische Ausfalldaten für das computerimplementierte Modell ermittelbar sein.

In einer weiteren Ausführungsform der Vorrichtung können die Ausfallsdaten durch eine künstliche Alterung der weiteren Leistungselektronikbaugruppe ermittelbar sein.

In einer weiteren Ausführungsform der Vorrichtung kann das computerimplementierte Modell ein thermisches Modell der Leistungselektronikbaugruppe aufweisen.

In einer weiteren Ausführungsform der Vorrichtung kann das computerimplementierte Modell eine künstliche Intelligent aufweisen.

Weitere Besonderheiten und Vorteile der Erfindung werden aus den nachfolgenden Erläuterungen eines Ausführungsbeispiels anhand von schematischen Zeichnungen ersichtlich.

### KURZE BESCHREIBUNG DER ZEICHNUNGEN

Es zeigen:
FIG. 1 eine Darstellung der Lage der Temperaturmesssensoren in einer beispielhaften Leistungselektronikbaugruppe,
FIG. 2 ein Schaubild des Verfahrens zur Abschätzung der Restlebensdauer,
FIG. 3 ein Ablaufdiagramm des Verfahrens zur Abschätzung der Restlebensdauer, und
FIG. 4 ein Blockschaltbild der Vorrichtung zur Abschätzung der Restlebensdauer.

### DETAILLIERTE BESCHREIBUNG DER ERFINDUNG

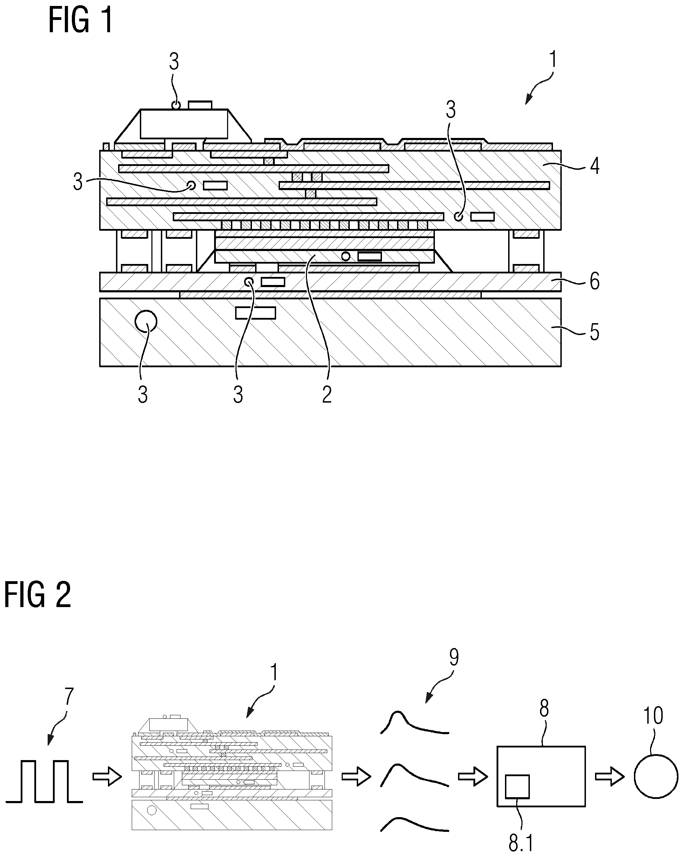

FIG. 1 zeigt eine schematische Schnittansicht einer beispielhaften Leistungselektronikbaugruppe 1, auch als Leistungsmodul bezeichenbar. Die Leistungselektronikbaugruppe 1 weist einen Kühlkörper 5 auf, auf dem ein DCB-Substrat 6 und damit verbunden (bspw. gelötet oder gesintert) Leistungshalbleiter 2 angeordnet sind. Darüber befindet sich ein Hauptverdrahtungsträger 4.

An verschiedenen Orten (siehe FIG. 1) in der Leistungselektronikbaugruppe 1 sind Temperaturmesssensoren 3 angeordnet, die zeitliche Temperaurverläufe messen und an eine nicht dargestellte Recheneinheit übertragen können. Mit Hilfe der zahlreichen Temperaturmesssensoren 3 kann ein zeitlich aufgelöste Temperaturfeld an jedem Ort der gesamten Leistungselektronikbaugruppe 1 abgeschätzt werden.

FIG. 2 ein Schaubild des Verfahrens zur Abschätzung der Restlebensdauer 10 einer Leistungselektronikbaugruppe 1 gemäß der Darstellung in FIG. 1. Die Leistungshalbleiter 2 werden mit einer vordefinierten Schaltpulsfolge 7 einer definierten Zeitdauer, beispielsweise 20 Sekunden, angesteuert, wodurch sich die Leistungselektronikbaugruppe 1 samt ihrer Komponenten erwärmt.

Die Temperaturmesssensoren 3 messen die zeitlichen Temperaturverläufe 9 über einen definierten Zeitraum, beispielsweise 40 Sekunden. Die Temperaturverläufe 9 werden einer Recheneinheit 8 zugeführt. Die Recheneinheit 8 weist ein vorab ermitteltes, computerimplementierten Modell 8.1 der temperaturbedingten Degradation der Leistungselektronikbaugruppe 1 auf. Mit Hilfe des Modells 8.1 kann die Recheneinheit 8 die Restlebensdauer 10 der Leistungselektronikbaugruppe 1 abschätzen. Durch diese Kenntnis kann die Leistungselektronikbaugruppe 1 rechtzeitig repariert oder ausgewechselt werden.

Das Modell 8.1 wird vorteilhaft empirisch mit Hilfe einer gleichen weiteren Leistungselektronikbaugruppe vorab ermittelt. Dabei können beispielsweise Ausfalldaten für das computerimplementierte Modell ermittelt werden. Bevorzugt können die Ausfallsdaten durch eine künstliche Alterung der weiteren Leistungselektronikbaugruppe ermittelt werden. Das computerimplementierte Modell 8.1 kann ein thermisches Modell der Leistungselektronikbaugruppe 1 und/oder eine künstliche Intelligenz für die Abschätzung der Restlebensdauer 10 aufweisen.

Die Recheneinheit 8 kann als Edge-Hardware oder als Cloud-Service ausgebildet sein.

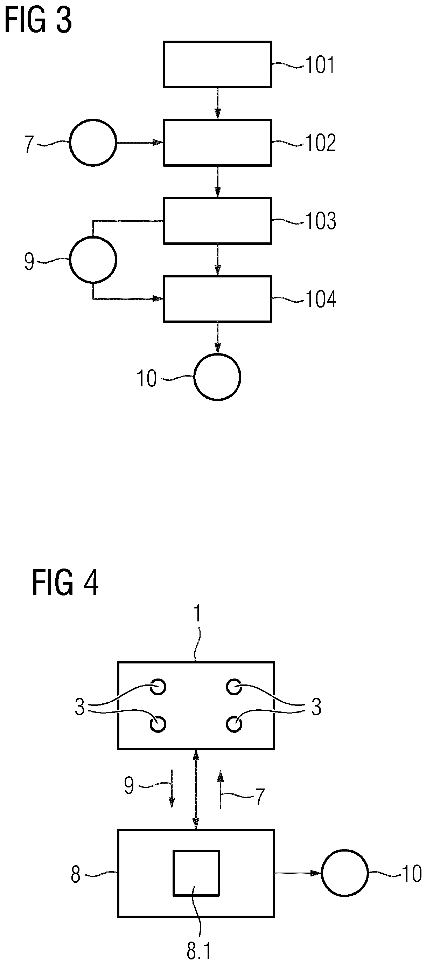

FIG. 3 zeigt ein Ablaufdiagramm des Verfahrens zur Abschätzung der Restlebensdauer 10 einer Leistungselektronikbaugruppe 1 wie in FIG. 1 dargestellt. In einem ersten Schritt 101 wird eine Betriebsspannung an die Leistungselektronikbaugruppe 1 angelegt, so dass diese betriebsbereit ist. In einem zweiten Schritt 102 werden Leistungshalbleiter 2 der Leistungselektronikbaugruppe 1 mit einer vordefinierten Schaltpulsfolge 7 angesteuert. Vorzugsweise über einen Zeitraum von etwa 20 Sekunden.

In einem weiteren Schritt 103 werden zeitliche Temperaturverläufe 9 durch in der Leistungselektronikbaugruppe 1 angeordnete Temperaturmesssensoren 3 ermittelt. In dem abschließenden Schritt 104 wird eine temperaturbedingte Restlebensdauer 10 der Leistungselektronikbaugruppe 1 mit Hilfe eines computerimplementierten Modells 8.1 der temperaturbedingten Degradation der Leistungselektronikbaugruppe 1 anhand der ermittelten Temperaturverläufe 9 abgeschätzt.

Das computerimplementierte Modell 8.1 wurde an einer gleichen oder sehr ähnlichen weiteren Leistungselektronikbaugruppe vorab vorzugsweise empirisch ermittelt.

FIG. 4 zeigt ein Blockschaltbild einer Vorrichtung zur Abschätzung der Restlebensdauer 10 einer Leistungselektronikbaugruppe 1. Eine Recheneinheit 1 mit einem computerimplementierten Modell 8.1 der temperaturbedingten Degradation der Leistungselektronikbaugruppe 1 steuert die betriebsbereite Leistungselektronikbaugruppe 1 mit einer vordefinierten Schaltpulsfolge 7 an, wodurch sich die Leistungselektronikbaugruppe 1 erwärmt und ein Temperaturfeld sich ausbildet. Dieses wird mittel der Temperaturmesssensoren 3 gemessen und deren zeitlichen Temperaturverläufe 9 an die Recheneinheit 8 übertragen.

Mit Hilfe des computerimplementierten Modell 8.1 wird die Restlebensdauer 10 der Leistungselektronikbaugruppe 1 abgeschätzt. Vorzugsweise wird die Restlebensdauer 10 definiert als Zeitraum, bis zu dem die fortschreitende Degradation der Leistungselektronikbaugruppe 1 zu einem Ausfall der Leistungselektronikbaugruppe 1 führt. Dazu wird ein Ausfallkriterium gewählt. Durch die Kenntnis der abgeschätzten Restlebensdauer 10 kann die Leistungselektronikbaugruppe 1 rechtzeitig repariert oder ersetzt werden, um einem Ausfall vorzubeugen.

Obwohl die Erfindung im Detail durch die Ausführungsbeispiele näher illustriert und beschrieben wurde, ist die Erfindung durch die offenbarten Beispiele nicht eingeschränkt und andere Variationen können vom Fachmann daraus abgeleitet werden, ohne den Schutzumfang der Erfindung zu verlassen.

### Bezugszeichenliste

- 1: Leistungselektronikbaugruppe
- 2: Leistungshalbleiter
- 3: Temperaturmesssensor
- 4: Hauptverdrahtungsträger
- 5: Kühlkörper
- 6: DCB
- 7: Schaltpulsfolge
- 8: Recheneinheit
- 8.1: Computerimplementiertes Modell
- 9: Temperaturverlauf
- 10: Restlebensdauer

- 101: Anlegen der Betriebsspannung
- 102: Ansteuern des Leistungshalbleiters
- 103: Ermitteln der Temperaturverläufe
- 104: Abschätzen der Restlebensdauer

## Patentansprüche

1. Ein automatisiertes Verfahren zur Abschätzung der temperaturbedingten Restlebensdauer (10) einer Leistungselektronikbaugruppe (1), wobei die Leistungselektronikbaugruppe (1) mindestens einen, betriebsbedingt Verlustwärme abgebenden, schaltbaren Leistungshalbleiter (2) sowie mehrere Temperaturmesssensoren (3) aufweist,
**gekennzeichnet durch**:
- ein Anlegen (101) einer Betriebsspannung an die Leistungselektronikbaugruppe (1),
- ein Ansteuern (102) des Leistungshalbleiters (2) mit einer vordefinierten Schaltpulsfolge (7),
- ein Ermitteln (103) von zeitlichen Temperaturverläufen (9) **durch** die Temperaturmesssensoren (3), und
- ein Abschätzen (104) der temperaturbedingten Restlebensdauer (10) der Leistungselektronikbaugruppe (1) mit Hilfe eines computerimplementierten Modells (8.1) der temperaturbedingten Degradation der Leistungselektronikbaugruppe (1) anhand der ermittelten Temperaturverläufe (9).

2. Das Verfahren nach Anspruch 1,
**dadurch gekennzeichnet,**
**dass** die Schaltpulsfolge (7) eine vordefinierte Pulsfolgendauer aufweist und die Temperaturverläufe (9) über eine vordefinierte Messdauer ermittelt werden.

3. Das Verfahren nach Anspruch 1 oder 2,
dadurch gegenzeichnet,
dass das computerimplementierte Modell (8.1) empirisch an einer der Leistungselektronikbaugruppe (1) identischen oder ähnlichen weiteren Leistungselektronikbaugruppe ermittelt wird.

4. Das Verfahren nach Anspruch 3,
**dadurch gekennzeichnet,**
**dass** an der weiteren Leistungselektronikbaugruppe empirische Ausfalldaten für das computerimplementierte Modell (8.1) ermittelt werden.

5. Das Verfahren nach Anspruch 4,
**dadurch gekennzeichnet,**
**dass** die Ausfallsdaten durch eine künstliche Alterung der weiteren Leistungselektronikbaugruppe ermittelt wird.

6. Das Verfahren nach einem der vorhergehenden Ansprüche,
**dadurch gekennzeichnet,**
**dass** das computerimplementierte Modell (8.1) ein thermisches Modell der Leistungselektronikbaugruppe (1) aufweist.

7. Das Verfahren nach einem der vorhergehenden Ansprüche,
**dadurch gekennzeichnet,**
**dass** das computerimplementierte Modell (8.1) eine künstliche Intelligent aufweist.

8. Eine Vorrichtung zur Abschätzung der temperaturbedingten Restlebensdauer (10) einer Leistungselektronikbaugruppe (1), wobei die Leistungselektronikbaugruppe (1) mindestens einen, betriebsbedingt Verlustwärme abgebenden, schaltbaren Leistungshalbleiter (2) sowie mehrere Temperaturmesssensoren (3) aufweist,
**gekennzeichnet durch**:
eine Recheneinheit (8), die ausgebildet und eingerichtet ist, bei einer angelegten Betriebsspannung an der Leistungselektronikbaugruppe (1),
- den Leistungshalbleiter (2) mit einer vordefinierten Testpulsfolge (7) anzusteuern,
- **durch** die Temperaturmesssensoren (3) ermittelte zeitliche Temperaturverläufe (9) zu erfassen, und
- die temperaturbedingte Restlebensdauer (10) der Leistungselektronikbaugruppe (1) mit Hilfe eines computerimplementierten Modells (8.1) der temperaturbedingten Degradation der Leistungselektronikbaugruppe (1) anhand der ermittelten Temperaturverläufe (9) abzuschätzen.

9. Die Vorrichtung nach Anspruch 8,
**dadurch gekennzeichnet,**
**dass** die Recheneinheit (10) als Edge-Hardware oder als Cloud-Service ausgebildet ist.

10. Die Vorrichtung nach Anspruch 8 oder 9,
dadurch gegenzeichnet,
dass das computerimplementierte Modell (8.1) empirisch an einer der Leistungselektronikbaugruppe (1) identischen oder ähnlichen weiteren Leistungselektronikbaugruppe ermittelbar ist.

11. Die Vorrichtung nach einem der Ansprüche 8 bis 10,
**dadurch gekennzeichnet,**
**dass** an der weiteren Leistungselektronikbaugruppe empirische Ausfalldaten für das computerimplementierte Modell (10) ermittelbar ist.

12. Die Vorrichtung nach Anspruch 11,
**dadurch gekennzeichnet,**
**dass** die Ausfallsdaten durch eine künstliche Alterung der weiteren Leistungselektronikbaugruppe ermittelbar sind.

13. Die Vorrichtung nach einem der Ansprüche 8 bis 12,
**dadurch gekennzeichnet,**
**dass** das computerimplementierte Modell (8.1) ein thermisches Modell der Leistungselektronikbaugruppe (1) aufweist.

14. Die Vorrichtung nach einem der Ansprüche 8 bis 13,
**dadurch gekennzeichnet,**
**dass** das computerimplementierte Modell (8.1) eine künstliche Intelligent aufweist.

15. Die Vorrichtung nach einem der Ansprüche 8 bis 14,
**dadurch gekennzeichnet,**
**dass** die Leistungselektronikbaugruppe (1) ein Stromrichter ist.
